# EUROPEAN PATENT APPLICATION

(11) **EP 4 601 430 A2**
(43) Date of publication of application: **13.08.2025**
(21) Application number: 25181147.7
(22) Date of filing: 05.06.2025
(51) Int. Cl.: H05K 7/20

(54) **POWER CONVERSION SYSTEM, ENERGY STORAGE SYSTEM AND ELECTRIC EQUIPMENT**

(30) Priority: 27.04.2025 CN 202510540656; 28.04.2025 CN 202510541992
(71) Applicant: Zhejiang Jinko Energy Storage Co., Ltd., Jiaxing, Zhejiang 314415 (CN)
(72) Inventor: Lu, Yang, Haining, 314415 (CN); XU, Guodong, Haining, 314415 (CN); Yu, Jian, Haining, 314415 (CN); CHENG, Min, Haining, 314415 (CN); SUN, Xuebing, Haining, 314415 (CN); ZHANG, Luhua, Haining, 314415 (CN)
(74) Representative: Haseltine Lake Kempner LLP

(57) **Abstract**

A power conversion system includes at least a liquid cooling member, a plurality of devices, an air cooling assembly, and a plurality of heat pipes. The liquid cooling member has a liquid cooling channel, the liquid cooling member has a first side and a second side opposite to each other in a first direction, and the first side has a plurality of mounting regions. The plurality of devices are arranged in the plurality of mounting regions. The air cooling assembly is disposed on the first side. The air cooling assembly includes an airflow generating member and a heat dissipation member located on an airflow path generated by the airflow generating member. The plurality of heat pipes are arranged in the plurality of mounting regions.

## Description

### TECHNICAL FIELD

The present application relates to the field of energy storage technologies, and in particular, to a power conversion system, an energy storage system, and an electrical equipment.

### BACKGROUND

With the development of new energy industry, the power of power conversion systems continues to increase. With the continuous improvement of power, electric energy consumed by power devices in a power conversion system, such as an insulated gate bipolar transistor (IGBT) and a power diode, is greatly increased during operation. This significant increase in power consumption directly causes the device to release a large amount of heat during operation.

Therefore, how to improve a thermal management effect of the power conversion system is an urgent problem to be resolved.

### SUMMARY

Accordingly, it is necessary to provide a power conversion system, an energy storage system, and an electrical equipment, to improve a thermal management effect of the power conversion system.

A power conversion system includes a liquid cooling member, a plurality of devices, an air cooling assembly, and a plurality of heat pipes. The liquid cooling member has a liquid cooling channel, the liquid cooling member has a first side and a second side opposite to each other along a first direction, and the first side has a plurality of mounting regions. The plurality of devices are arranged in one-to-one correspondence with the plurality of mounting regions. The air cooling assembly is disposed on the first side. The air cooling assembly includes an airflow generating member and a heat dissipation member located on an airflow path generated by the airflow generating member. The plurality of heat pipes are disposed in one-to-one correspondence with the plurality of mounting regions. One end of each heat pipe is located in a corresponding mounting region, the other end of the heat pipe is located between the heat dissipation member and the liquid cooling member, and the heat dissipation member is attached to a side of the heat pipe away from the liquid cooling member.

The power conversion system at least includes a liquid cooling member, a plurality of components, an air cooling assembly, and a plurality of heat pipes. Because one end of each heat pipe is located in the corresponding mounting region, and the other end of the heat pipe is located between the heat dissipation member and the liquid cooling member, the liquid cooling member can be further used to perform thermal management on the heat pipe, thereby helping to improve a heat dissipation effect of the device in the mounting region. Because the heat dissipation member is located on the airflow path generated by the airflow generating member, and the heat dissipation member may also cooperate with the heat pipe to further use the cooling capacity of the liquid cooling member, the airflow generated by the airflow generating member may be used to dissipate heat of the device. In addition, the heat pipe, the liquid cooling member, the heat dissipation member, and the airflow generating member cooperate with each other, so that a cold energy in a region in which the heat pipe, the heat dissipation member, and the liquid cooling member overlap can jointly dissipate heat for the device in cooperation with the airflow generated by the airflow generating member. Therefore, the power conversion system provided in the embodiment of present application can improve a thermal management effect of the power conversion system.

### BRIEF DESCRIPTION OF THE DRAWINGS

FIG. 1 is a perspective view of a power conversion system according to some embodiments of present application.
FIG. 2 is a perspective view of a power conversion system with some structures removed according to some embodiments of present application.
FIG. 3 is a top view of the power conversion system in FIG. 2.
FIG. 4 is a top view of the power conversion system with still another partial structure removed according to some embodiments of present application.
FIG. 5 is a perspective view of a liquid cooling member according to some embodiments of present application.
FIG. 6 is a top view of a first liquid cooling portion of the liquid cooling member from one aspect according to some embodiments of present application.
FIG. 7 is a top view of the first liquid cooling portion of the liquid cooling member from another aspect according to some embodiments of present application.
FIG. 8 is a perspective view of a second liquid cooling portion of the liquid cooling member according to some embodiments of present application.
FIG. 9 is a top view of the power conversion system with some structures removed according to some other embodiments of present application.
FIG. 10 is a top view of a flow disturbing structure disposed in a first buffer section according to some embodiments of present application.
FIG. 11 is a top view of a flow disturbing structure disposed in a first buffer section according to some other embodiments of present application.
FIG. 12 is a top view of a flow disturbing structure disposed in a first buffer section according to some other embodiments of present application.
FIG. 13 is a perspective view of cooperation between a heat dissipation member and an airflow generating member according to some embodiments of present application.
FIG. 14 is a perspective view of the power conversion system with some structures removed and from one aspect according to some other embodiments of present application.
FIG. 15 is a perspective view of the power conversion system with some structures removed and from another aspect according to some other embodiments of present application.
FIG. 16 is a perspective view of the structure shown in FIG. 14 with part of the structure removed.
FIG. 17 is a top view of the structure shown in FIG. 16.
FIG. 18 is a perspective view of the power conversion system with some structures removed according to some other embodiments of present application.
FIG. 19 is a perspective view of a heat dissipation member according to some embodiments of present application.
FIG. 20 is a perspective view of a heat dissipation member according to some other embodiments of present application.

### DETAILED DESCRIPTION OF THE EMBODIMENTS

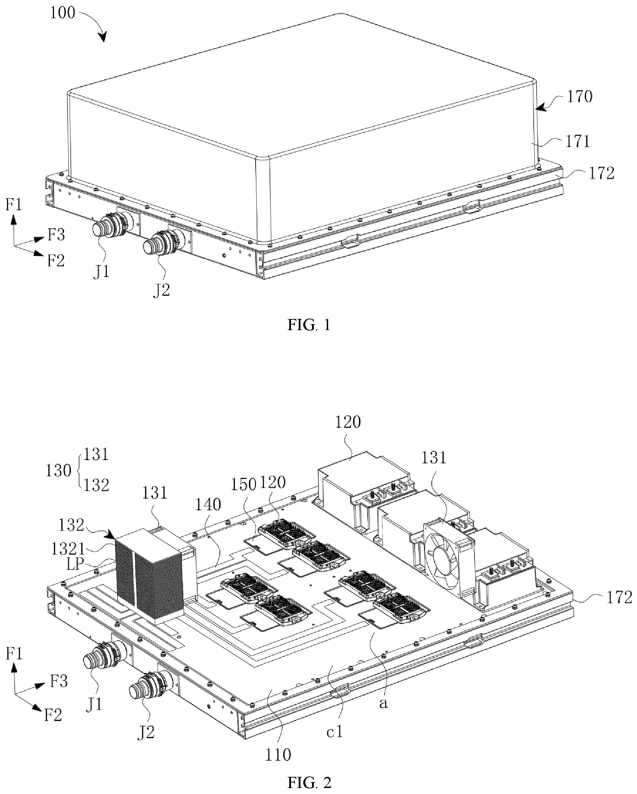

Referring to FIG. 1 to FIG. 3, an embodiment of present application provides a power conversion system 100, including a liquid cooling member 110, a plurality of devices 120, an air cooling assembly 130, and a plurality of heat pipes 140.

The liquid cooling member 110 has a liquid cooling channel UP. The liquid cooling member 110 has a first side c1 and a second side c2 opposite to each other along a first direction F1, and the first side c1 has a plurality of mounting regions a. The plurality of devices 120 are disposed in the plurality of mounting regions a in one-to-one correspondence. The devices 120 are disposed in the corresponding mounting regions a. The air cooling assembly 130 is disposed on the first side c1. The air cooling assembly 130 includes an airflow generating member 131 and a heat dissipation member 132. The heat dissipation member 132 is located on an airflow path generated by the airflow generating member 131. The plurality of heat pipes 140 are disposed in the plurality of mounting regions a in one-to-one correspondence. One end of the heat pipe 140 is located in the corresponding mounting region a, and the other end of the heat pipe 140 is located between the heat dissipation member 132 and the liquid cooling member 110. The heat dissipation member 132 is attached to a side of the heat pipe 140 away from the liquid cooling member 110.

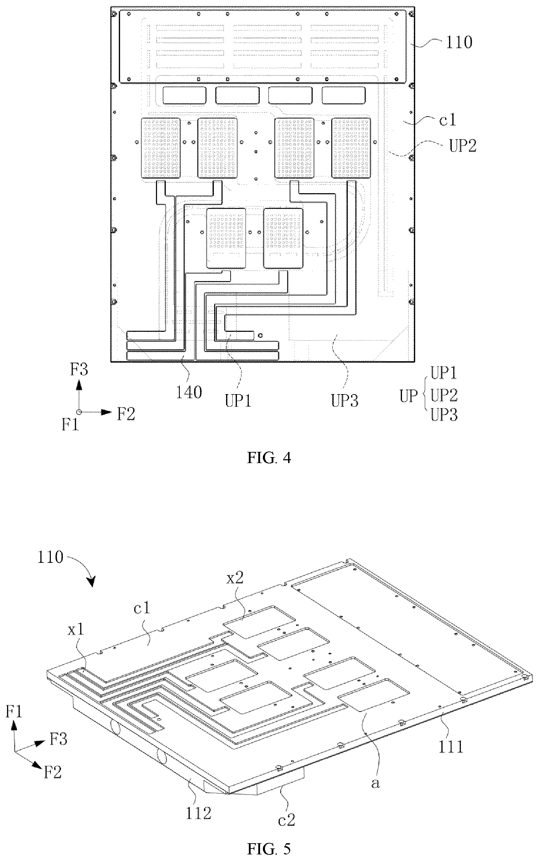

The liquid cooling member 110 is a component that performs thermally management on related components through a liquid cooling manner. The liquid cooling channel UP is a channel inside the liquid cooling member 110 configured to guide a coolant to flow. Referring to FIG. 4, the liquid cooling channel UP is illustrated as a dashed line. The coolant flows in the liquid cooling channel UP, and performs heat exchange with the heat absorbed by the liquid cooling member 110 through a wall surface of the liquid cooling channel UP, so as to take away the heat. The heat absorbed by the liquid cooling member 110 is the heat generated by heat exchange between the liquid cooling member 110 and the heat source in contact with the liquid cooling member 110.

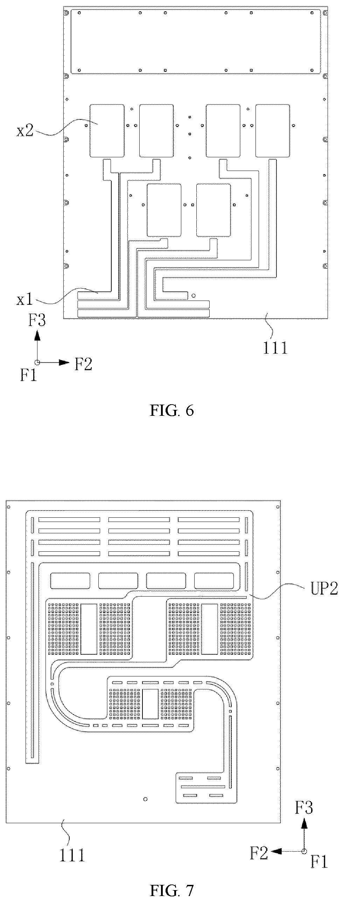

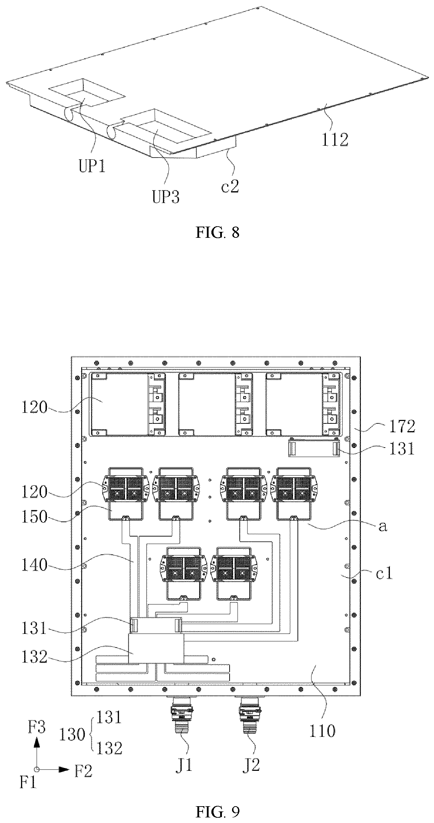

Referring to FIGS. 5 to 8, the liquid cooling member 110 has a first side c1 and a second side c2 opposite to each other along a first direction F1. The first side c1 has a plurality of mounting regions a. The liquid cooling member 110 includes a first liquid cooling portion and a second liquid cooling portion, and the first liquid cooling portion and the second liquid cooling portion are stacked along the first direction F1. Opposite sides of the first liquid cooling portion and the second liquid cooling portion define the liquid cooling channel UP. For example, one side of the first liquid cooling portion facing the second liquid cooling portion may be recessed to form the liquid cooling channel UP. Alternatively, one side of the second liquid cooling portion facing the first liquid cooling portion may be recessed to form the liquid cooling channel UP. Alternatively, one side of the first liquid cooling portion and one side of the second liquid cooling portion facing each other may both be recessed to form the liquid cooling channel UP, which is not specifically limited herein. In FIG. 7 and FIG. 8, it is illustrated that the first liquid cooling portion and the second liquid cooling portion are both recessed on their sides facing each other to form the liquid cooling channel UP. It should be noted that only a part of the liquid cooling channel UP is shown in FIG. 7 and FIG. 8.

The device 120 refers to various electronic elements, components, or assemblies that may be used to construct an electronic device, circuitry, or other device. The device 120 may include a capacitor, a relay, a transformer, a Hall element, an insulated gate bipolar transistor (IGBT) module, a power transistor, and the like, which is not specifically limited herein. The device 120 is disposed in the corresponding mounting region a, that is, the device 120 is disposed on the first side c1 of the liquid cooling member 110, and the device 120 may exchange heat with the first side c1 of the liquid cooling member 110.

The air cooling assembly 130 is a heat dissipation device that uses air flow to take away heat. The airflow generating member 131 is a component that generates airflow in the air cooling assembly 130, and functions to enable air to flow in a certain manner to form airflow with a certain speed and flow rate to provide power for heat dissipation. The heat dissipation member 132 is a component that can perform heat exchange with other components in the air cooling assembly 130. Specifically, since the heat dissipation member 132 is located on the airflow path generated by the airflow generating member 131, and the heat dissipation member 132 is attached to a side of the heat pipe 140 away from the liquid cooling member 110, the heat dissipation member 132 can exchange heat with the heat pipe 140, and can exchange heat with the airflow generated by the airflow generating member 131.

The heat pipe 140 is a device with high efficient heat transfer performance, and the heat pipe 140 implements rapid heat transfer by using a phase change of a working medium. The heat pipe 140 is generally composed of a tube shell, a wick, and an end cover, and the heat pipe 140 is vacuumed and filled with an appropriate amount of working medium.

Ends of both the device 120 and the heat pipe 140 are located in the mounting region a, that is, the heat pipe 140 and the device 120 may or may not be in contact. The device 120 may or may not completely cover the corresponding mounting region a, which is not specifically limited herein. When the device 120 completely covers the corresponding mounting region a, one end of the heat pipe 140 located in the corresponding mounting region a is located between the device 120 and the mounting region a. In this case, one end of the heat pipe 140 is located between the device 120 and the mounting region a, and one end of the heating pipe 140 is in contact with the device 120. When the device 120 does not completely cover the corresponding mounting region a, one end of the heat pipe 140 may or may not be in contact with the device 120. It may be understood that, heat exchange may be performed between one end of the heat pipe 140, the corresponding device 120, and the corresponding mounting region a. The other end of the heat pipe 140 is located between the heat dissipation member 132 and the liquid cooling member 110, that is, heat exchange may be performed between the other end of the heat pipe 140, the heat dissipation member 132, and the liquid cooling member 110.

Therefore, since one end of the heat pipe 140 is located in the corresponding mounting region a, and the other end of the heat pipe 140 is located between the heat dissipation member 132 and the liquid cooling member 110, the liquid cooling member 110 may be further used to perform thermal management on the heat pipe 140, thereby facilitating to improve a heat dissipation effect of the device 120 in the mounting region a. Since the heat dissipation member 132 is located on the airflow path generated by the airflow generating member 131, and the heat dissipation member 132 may also cooperate with the heat pipe 140 to further use the cooling capacity of the liquid cooling member 110, the device 120 may be dissipated by using the airflow generated by the airflow generating member 131. In addition, through the cooperation among the heat pipe 140, the liquid cooling member 110, the heat dissipation member 132, and the airflow generating member 131, a cold energy of a region in which the heat pipe 140, the heat dissipation member 132, and the liquid cooling member 110 are overlapped can cooperate with the airflow generated by the airflow generating element 131 to dissipate heat for the device 120. Therefore, the power conversion system 100 according to the embodiment of present application can improve the thermal management effect of the power conversion system 100.

It should be noted that, in the cooperation of the heat pipe 140, the liquid cooling member 110, the heat dissipation member 132, and the airflow generating member 131, the heat pipe 140 transfers the heat of the device 120 to a vicinity of the heat dissipation member 132 and the liquid cooling member 110, and the liquid cooling member 110 provides cooling capacity for the heat dissipation member 132 and the heat pipe 140, so as to reduce the temperature of the region and form a relatively low temperature region. The airflow generated by the airflow generating member 131 passes through the heat dissipation member 132, and the airflow can exchange heat with the heat dissipation member 132, so that the temperature of the airflow is reduced, and the airflow with the reduced temperature can continuously dissipate heat for the device 120. As such, a plurality of heat dissipation paths for performing heat dissipation on the device 120 are formed, and these heat dissipation paths are correlated with each other, which is conducive to improving heat dissipation uniformity, is conducive to enabling overall temperature distribution of the device 120 more uniform, and is conducive to prolonging a service life of the device 120.

According to some embodiments of present application, still referring to FIG. 2 to FIG. 4, the heat pipe 140 is attached to the first side c1 of the liquid cooling member 110.

The liquid cooling member 110 generally has good thermal conductivity and large heat capacity, and the heat pipe 140 is attached to the first side c1 of the liquid cooling member 110 and can be in direct contact with the liquid cooling member 110, so as to perform more efficient heat conduction. When the heat pipe 140 transfers heat from the mounting region a to the other end, the heat pipe 140 can quickly transfer the heat to the liquid cooling member 110, and use the coolant in the liquid cooling member 110 to take away the heat, thereby implementing rapid heat dissipation. In addition, the heat pipe 140 is attached to the first side c1 of the liquid cooling member 110, so that heat dissipation conditions of all parts of the heat pipe 140 are more consistent, thereby improving overall heat dissipation performance of the heat pipe 140, enabling each device 120 in the mounting region a to obtain relatively uniform heat dissipation, reducing a temperature difference between the devices 120, and improving stability and reliability of the entire system. In addition, attaching the heat pipe 140 to the first side c1 of the liquid cooling member 110 can make full use of the surface space of the liquid cooling member 110, so that the layout of the entire heat dissipation system is more compact.

Certainly, in some other embodiments, the heat pipe 140 may not be attached to the first side c1 of the liquid cooling member 110. For example, a gap is formed between at least a portion of the heat pipe 140 and the first side c1 of the liquid cooling member 110. In this case, at least a part of the heat pipe 140 may be located on the airflow path generated by the airflow generating member 131, so that heat exchange may also be performed between the heat pipe 140 and the airflow, which is not specifically limited herein.

According to some embodiments of present application, still referring to FIG. 2 to FIG. 4, orthographic projections of all heat pipes 140 on a reference plane do not overlap with each other, and the reference plane is a plane perpendicular to the first direction F1. That is, all the heat pipes 140 are located in different regions of the first side c1 of the liquid cooling member 110.

In this way, not only the liquid cooling member 110 can be more fully utilized, such that the heat exchange between the heat pipes 140 and the liquid cooling member 110 is more sufficient, thereby improving the heat dissipation efficiency, but also each heat pipe 140 can independently exchange heat with the liquid cooling member 110, thus reducing the mutual influence of the heat between the heat pipes 140, thereby improving the heat dissipation effect. In addition, this layout also facilitates installation and maintenance of the heat pipe 140.

According to some embodiments of present application, still referring to FIG. 2 to FIG. 6, the first side c1 of the liquid cooling member 110 is provided with a plurality of first recesses x1, and the plurality of first recesses x1 and the plurality of heat pipes 140 are provided in a one-to-one correspondence. The heat pipe 140 is disposed in the corresponding first recess x1, that is, the heat pipe 140 is embedded in one side of the liquid cooling member 110.

The heat pipes 140 and the first recesses x1 of the liquid cooling member 110 are arranged in one-to-one correspondence, so that the heat pipes 140 can be closely attached to the liquid cooling member 110, and a contact area between the heat pipes 140 and the liquid cooling member 110 is effectively increased, so that the heat is more efficiently transferred from the heat pipes 140 to the liquid cooling member 110, and then is taken away by the coolant in the liquid cooling member 110, thereby improving heat dissipation efficiency. In addition, the first recess x1 can not only improve mounting stability of the heat pipe 140, but also can fully use space on the first side c1 of the liquid cooling member 110, so as to implement a more compact structural layout.

According to some embodiments of present application, still referring to FIG. 2, FIG. 3, FIG. 5, and FIG. 6, the power conversion system 100 further includes a plurality of heat spreaders 150. The plurality of heat spreaders 150 are provided in the plurality of mounting regions a in one-to-one correspondence, each heat spreader 150 is located in the corresponding mounting region a. The corresponding device 120 is disposed on a side of the heat spreader 150 away from the liquid cooling member 110. Mounting regions a corresponding to the heat spreader 150 and the corresponding device 120 are the same mounting region a.

The heat spreader 150 is a flat plate with high thermal conductivity, which is usually made of a metal material. The heat spreader 150 may be internally provided with structures such as a microchannel or a capillary structure, which can achieve rapid heat transfer and more uniform temperature distribution.

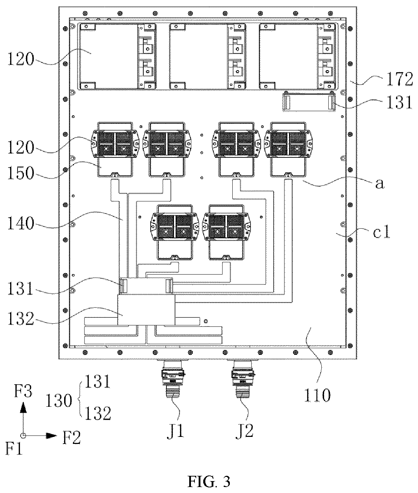

For example, taking FIG. 2 and FIG. 3 as an example, the device 120 disposed on the side of the heat spreader 150 away from the liquid cooling member 110 may be an IGBT. Certainly, the device 120 may alternatively be other components such as an inductor, which is not specifically limited herein.

In this way, by providing the heat spreader 150, the heat generated by the device 120 in contact with the heat spreader 150 can be quickly diffused and more evenly distributed on the entire surface of the heat spreader 150, thereby improving the local overheating of the device 120, and improving the working stability and reliability of the device 120.

According to some embodiments of present application, still referring to FIG. 2, FIG. 3, FIG. 5, and FIG. 6, the heat spreader 150 is embedded in the first side c1 of the liquid cooling member 110.

Specifically, referring to FIG. 5 and FIG. 6, the first side c1 of the liquid cooling member 110 is provided with a plurality of second recesses x2, and the plurality of second recesses x2 and the plurality of heat spreaders 150 are arranged in one-to-one correspondence. The heat spreader 150 is disposed in the corresponding second recess x2, so that the heat spreader 150 is embedded in the first side c1 of the liquid cooling member 110.

Since the heat spreader 150 is disposed in one-to-one correspondence with the second recesses x2 of the liquid cooling member 110, the heat spreader 150 can be closely attached to the liquid cooling member 110, and a contact area between the heat spreader 150 and the liquid cooling member 110 is effectively increased, so that heat is more efficiently transferred from the heat spreader 150 to the liquid cooling member 110, and then is taken away by the coolant in the liquid cooling member 110, thereby improving heat dissipation efficiency. In addition, the second recess x2 not only can improve mounting stability of the heat spreader 150, but also can make full use of space on the first side c1 of the liquid cooling member 110, so as to implement a more compact structural layout.

According to some embodiments of present application, referring to FIG. 9, One end of the heat pipe 140 located in the corresponding mounting region a is connected to a corresponding heat spreader 150, and the mounting regions of a corresponding heat pipe 140 and a corresponding heat spreader 150 are the same mounting region a.

The heat spreader 150 can quickly collect and more evenly distribute the heat generated by the device 120, and the heat pipe 140 is connected to the heat spreader 150, so that the heat on the heat spreader 150 can be taken away in time. The heat is transferred to the liquid cooling member 110 by using the efficient heat conduction characteristic of the heat pipe 140, to quickly dissipate the heat and effectively reduce the temperature of the device 120. It may be understood that, in this connection manner, the heat spreader 150 and the heat pipe 140 form a collaborative heat dissipation system, and the two cooperate with each other to further improve heat dissipation efficiency of the entire mounting region a, so that the device 120 can work in a more stable temperature environment.

According to some embodiments of present application, still referring to FIG. 3, one end of the heat pipe 140 located in the corresponding mounting region a is spaced apart from the corresponding heat spreader 150, and the corresponding heat pipe 140 and the corresponding heat spreader 150 are both disposed in the same mounting region a.

In this way, the heat pipe 140 and the heat spreader 150 are spaced apart, so that the heat pipe 140 and the heat spreader 150 can work more independently, and it is convenient to install and maintain the heat pipe 140 and the heat spreader 150.

According to some embodiments of present application, referring to FIG. 2, FIG. 3, and FIG. 9, the heat spreader 150 is welded to the liquid cooling member 110. In this way, a tighter combination can be formed between the heat spreader 150 and the liquid cooling member 110, and contact thermal resistance between the heat spreader 150 and the liquid cooling member 110 can be reduced as much as possible, so that heat can be efficiently transferred from the heat spreader 150 to the liquid cooling member 110, heat dissipation efficiency is improved, and connection reliability between the heat spreader 150 and the liquid cooling member 110 can also be improved.

According to some embodiments of present application, referring to FIG. 2, FIG. 3, and FIG. 9, the heat spreader 150 is adhesively connected to the liquid cooling member 110. For example, the heat spreader 150 may be connected to the liquid cooling member 110 by using a thermally conductive adhesive.

Since the thermally conductive adhesive can fill the small gap between the heat spreader 150 and the liquid cooling member 110, the contact between the heat spreader 150 and the liquid cooling member 110 is tighter, and the existence of the air layer is reduced, thereby reducing the contact thermal resistance and improving the heat transfer efficiency. At the same time, such a connection manner can play a certain role of sealing and improve the situation that impurities such as dust and moisture enter the connection portion, thereby improving the heat dissipation effect.

According to some embodiments of present application, still referring to FIG. 4, FIG. 7, and FIG. 8, the liquid cooling channel UP includes a first buffer section UP1 and a main section UP2. The first buffer section UP1 is in communication with an inlet of the liquid cooling channel UP, and the main section UP2 is in communication with the first buffer section UP1 and an outlet of the liquid cooling channel UP. The orthographic projection of the first buffer section UP1 on the reference plane, the orthographic projection of the heat pipe 140 on the reference plane, and the orthographic projection of the heat dissipation member 132 on the reference plane have overlapping portions. An orthographic projection of the main section UP2 on the reference plane overlaps with orthographic projections of the plurality of devices 120 on the reference plane. The reference plane is a plane perpendicular to the first direction F1.

The first buffer section UP1 is a part of the liquid cooling channel UP connected to the inlet, and is mainly configured to buffer the coolant flowing into the liquid cooling channel UP. The coolant may decelerate and diffuse in the first buffer section UP1 to form a relatively stable and uniform flow state, and then smoothly enter the main section UP2. The first buffer section UP1, the heat pipe 140, and the heat dissipation member 132 are overlapped in projections, so that the first buffer section UP1 can better receive and process heat from the heat pipe 140 and the heat dissipation member 132, and perform heat exchange with the heat pipe 140 and the heat dissipation member 132.

In this way, since the coolant can be decelerated in the first buffer section UP1, a residence time of the coolant in the first buffer section UP1 can be prolonged, so that a heat exchange process among the first buffer section UP1, the heat pipe 140, and the heat dissipation member 132 can be more sufficient. In addition, the orthographic projection of the main section UP2 and orthographic projections of the plurality of devices 120 are overlapped, so that the liquid cooling channel UP can be closer to the device 120 and more directly cool the device 120, thereby improving pertinence and effectiveness of heat dissipation.

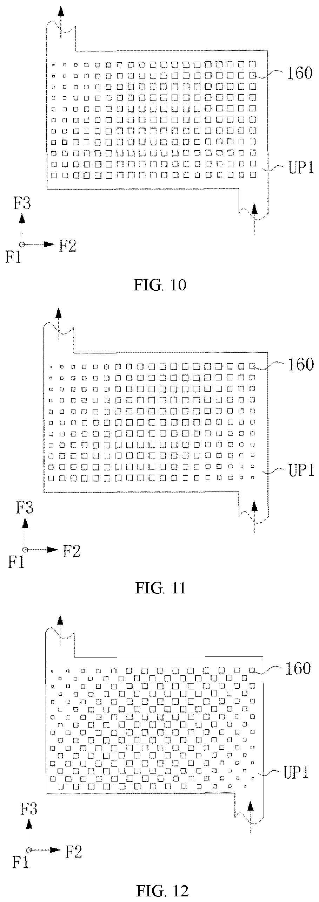

According to some embodiments of the present application, referring to FIG. 10, the power conversion system 100 further includes a plurality of flow disturbing structures 160. The plurality of flow disturbing structures 160 are arranged at intervals and provided in the first buffer section UP1.

The flow disturbing structure 160 can disturb the flow state of the coolant, so that the coolant forms a more complex flow field in the first buffer section UP1, thereby increasing the contact area and contact time between the coolant and the wall surface of the channel and the surrounding heating component. As such, heat transferred from the heat pipe 140, the heat dissipation member 132, and the like that are disposed adjacent to the first buffer section UP1 can be taken away more effectively, thereby increasing the heat exchange efficiency. In addition, the cooling capacity of the coolant flowing into the liquid cooling channel UP may be further distributed in the first buffer section UP1, so that the cooling capacity of the coolant is more fully utilized.

According to some embodiments of present application, still referring to FIG. 10, an extension direction of the liquid cooling channel UP from an inlet of the liquid cooling channel UP to an outlet of the liquid cooling channel UP is a reference direction. Along the reference direction, the distribution density of the plurality of flow disturbing structures 160 in a unit space region of the liquid cooling channel UP tends to decrease. In FIG. 10, the inflow direction and the outflow direction of the coolant are indicated by arrows.

The "unit space region" refers to a space range set as a target amount within the space range defined by the liquid cooling channel UP, that is, the unit space region is a region with a target volume. For example, the liquid cooling channel UP may be divided into several cubic regions having the same size, and each such cubic region may be regarded as a unit space region.

The distribution density in the unit space region is used to characterize the density of the flow disturbing structure 160. For example, the distribution density in the unit space region refers to a space proportion occupied by the flow disturbing structure 160 in the unit space region. If the sizes of all the flow disturbing structures 160 are the same and the flow disturbing structures 160 in the unit space region are completely located in the unit space region, the space occupied by the flow disturbing structures 160 in the unit space region is also equal to the number of the flow disturbing structures 160 in the unit space region multiplied by the space occupied by a single flow disturbing structure 160. If the sizes of all the flow disturbing structures 160 are not exactly the same and a part of the flow disturbing structures 160 in the unit space region are complete and a part of the flow disturbing structures 160 in the unit space region are incomplete, the space occupied by the flow disturbing structures 160 in the unit space region is the sum of the total space occupied by all the complete flow disturbing structures 160 in the unit space region and the total space occupied by all the incomplete flow disturbing structures 160 in the unit space region. The smaller the distribution density of the flow disturbing structure 160 in the unit space region is, the sparser the flow disturbing structure 160 is. To the contrast, the greater the distribution density of the flow disturbing structure 160 in the unit space region is, the denser the flow disturbing structure 160 is. The size and shape of the selected unit space region depends on the size definition of different unit space regions. After the unit space region size is defined, the size of the unit space region has a relative size and shape. For example, the size of the unit space region may be 1 cm³ (cubic centimeters), 1 mm³ (cubic millimeters), 1100 mm³ (cubic millimeters), or the like, which is not specifically limited in the embodiment of present application. It may be understood that each unit space region in all unit space regions has the same shape and the same size.

"In the reference direction, the distribution density of the plurality of flow disturbing structures 160 in the unit space region of the liquid cooling channel UP tends to decrease" refers to that, in the reference direction, the flow disturbing structures 160 tend to become sparse.

As such, the distribution density of the flow disturbing structure 160 adjacent to the inlet of the liquid cooling channel UP is relatively large, so that the contact area between the coolant and the flow disturbing structure 160 can be increased, the contact time between the coolant and the flow disturbing structure 160 can be prolonged, and heat exchange can be more fully performed. In addition, by providing the flow disturbing structures 160 with a decreasing distribution density, not only the pressure change of the coolant can be more gradual, and the occurrence of cavitation can be reduced, thereby improving the reliability and stability of the liquid cooling member 110, but also the coolant can beneficially flow into the main section UP2 from the first buffer section UP1.

According to some embodiments of the present application, still referring to FIG. 10, along the reference direction, the distribution density of the plurality of flow disturbing structures 160 in the unit space region of the liquid cooling channel UP gradually decreases.

When the coolant flows in the channel, its characteristics such as speed and pressure will change along the flow direction. Generally, as the coolant flows from the inlet of the liquid cooling channel UP to the outlet of the liquid cooling channel UP, the speed thereof gradually decreases, and the pressure thereof also gradually decreases. By configuring the distribution density of the flow disturbing structure 160 to gradually decrease, it is better adapted to the change in fluid characteristics, thereby facilitating the flow of the coolant in the circulation channel LP.

Certainly, in some other embodiments, along the reference direction, the distribution density of the plurality of flow disturbing structures 160 in the unit space region of the liquid cooling channel UP may be reduced stepwise. By adjusting the distribution density of the flow disturbing structures 160 in stages, the flow velocity, the flow direction and the turbulence degree of the coolant can be controlled in different stages, which is not specifically limited herein.

According to some embodiments of present application, referring to FIG. 11 and FIG. 12, FIG. 11 is a schematic view in which the flow disturbing structure 160 is disposed in the first buffer section UP1 in some other embodiments of present application, and FIG. 12 is a schematic view in which the flow disturbing structure 160 is disposed in the first buffer section UP1 in some other embodiments of present application. Along the reference direction, the distribution density of the flow disturbing structures 160 in the unit space region of the liquid cooling channel UP increases first and then decreases. In FIGS. 11 and 12, the inflow and outflow directions of the coolant are illustrated by arrows.

As such, the flow disturbing structure 160 tends to become dense first and then become sparse. As such, among all the flow disturbing structures 160, the flow disturbing structures 160 close to the inlet and the outlet are relatively sparse, and the flow disturbing structures 160 in the middle part are relatively dense, which not only helps to alleviate the blockage of the coolant when entering or leaving the first buffer section UP1, but also helps to improve the heat exchange effect with the heat pipe 140 and the heat dissipation member 132 by using the flow disturbing structures 160 in the middle part.

According to some embodiments of the present application, still referring to FIG. 10 to FIG. 11, all the flow disturbing structures 160 are arranged in rows along the second direction F2 and columns along the third direction F3. The first direction F1, the second direction F2, and the third direction F3 intersect in pairs. For example, the first direction F1, the second direction F2, and the third direction F3 are perpendicular to each other.

As such, by providing the regularly arranged flow disturbing structures 160, it is beneficial to controlling the distribution density of the flow disturbing structures 160.

According to some embodiments of the present application, referring to FIG. 12, all the flow disturbing structures 160 are arranged irregularly.

As such, by providing the irregularly arranged flow disturbing structures 160, the heat exchange effect between the coolant and the flow disturbing structures 160 is further improved.

According to some embodiments of present application, still referring to FIG. 4 and FIG. 8, the liquid cooling channel UP further includes a second buffer section UP3 connected between the main section UP2 and the outlet of the liquid cooling channel UP.

After the heat generating device 120 is cooled by the main section UP2, the flow rate and pressure of the coolant may fluctuate to some extent. The second buffer section UP3 may provide a relatively large space in which the coolant is temporarily buffered and stabilized, so that the flow rate of the coolant is more uniform and stable, thereby improving the overall reliability. As such, the leakage at the outlet caused by the pressure change at the outlet of the liquid cooling channel UP is avoided.

It should be noted that, corresponding flow disturbing structures may be provided in both the second buffer section UP3 and the main section UP2, so that a thermal management effect of the liquid cooling member 110 can be further improved. The structure and arrangement of the flow disturbing structure are not specifically limited.

According to some embodiments of present application, still referring to FIG. 1 to FIG. 3, the power conversion system 100 further includes a housing 170. The housing 170 has a receiving cavity, and the liquid cooling member 110 is received in the receiving cavity. The first side c1 of the liquid cooling member 110 and a cavity wall of the receiving cavity define an accommodating cavity, and the plurality of devices 120 and the air cooling assembly 130 are accommodated in the accommodating cavity. A plurality of airflow generating members 131 are provided, all of the airflow generating members 131 are configured to generate an annular airflow arranged around an axis in the accommodating cavity. The heat dissipation member 132 is located on a path of the annular airflow, and an extending direction of the axis and the first direction F1 are parallel to each other.

The housing 170 may include a first portion 171 and a second portion 172, and the first portion 171 and the second portion 172 cooperate to form the receiving cavity. FIG. 2 is a schematic view after removing the first portion 171. The second portion 172 may be provided with a liquid inlet joint J1 communicating with the inlet of the liquid cooling channel UP, and a liquid outlet joint J2 communicating with the outlet of the liquid cooling channel UP.

All of the airflow generating members 131 generate an annular airflow surrounding the axis, and the heat dissipation member 132 is located on a path of the annular airflow, so that the heat dissipation member 132 can be in sufficient contact with the airflow. Since the annular airflow may exchange heat with the heat dissipation member 132, the annular airflow may dissipate heat from a related component disposed on the first side c1 of the liquid cooling member 110. The liquid cooling member 110 and the annular airflow are combined to form a dual heat dissipation mechanism. The two heat dissipation manners cooperate with each other to better meet heat dissipation requirements under different working conditions, and improve heat dissipation performance and adaptability of the overall apparatus.

It should be noted that, the annular airflow can form a continuous airflow path surrounding the heat dissipation member 132 and the related heating component, thus fully covering the region that needs to dissipate heat. Compared with the conventional linear or local airflow, the annular airflow can more fully contact the heating surface to take away more heat, thereby improving the heat dissipation efficiency and improving the temperature uniformity of the overall apparatus.

According to some embodiments of present application, referring to FIG. 2, FIG. 3 and FIG. 13, FIG. 13 is a perspective view of cooperation between the heat dissipation member 132 and the airflow generating member 131 in some embodiments of present application. The heat dissipation member 132 includes at least one column of a plurality of heat dissipation portions 1321 arranged at intervals along the first direction F1, and each column of the heat dissipation portions 1321 defines a circulation channel LP. An inlet side of one of the airflow generating members 131 is connected to one side of the heat dissipation member 132, and an inlet of one of the airflow generating members 131 is in communication with the circulation channel LP.

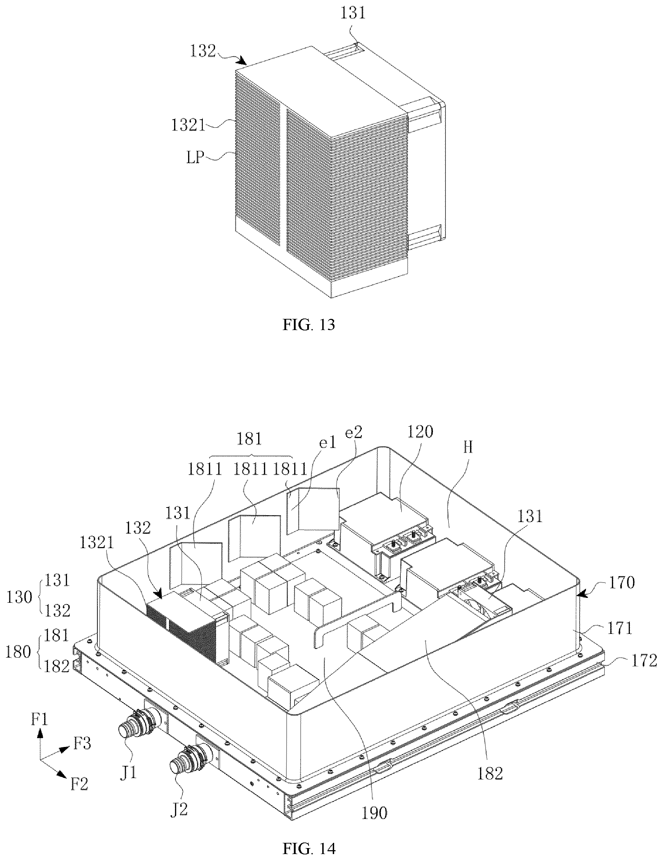

The heat dissipation portions 1321 may be arranged in one column, two columns or other number of columns, which is not specifically limited herein. Taking FIG. 13 as an example, the heat dissipation portions 1321 are arranged in two columns.

As such, the airflow entering the inlet side of the airflow generating member 131 first passes through the circulation channel LP. That is, the heat dissipation portion 1321 divides the airflow entering the inlet side of the airflow generating member 131, so that the airflow can more evenly contact each part of the heat dissipation member 132, thereby increasing an actual contact area between the airflow and the heat dissipation portion 1321. More airflow is in contact with the surface of the heat dissipation portion 1321, which can accelerate the heat exchange between the heat dissipation member 132 and the airflow, thereby improving the overall heat dissipation efficiency. Meanwhile, the airflow divided by the heat dissipation portion 1321 can better break the airflow boundary layer, reduce the thermal resistance, and further enhance the heat exchange effect.

It should be noted that, the heat dissipation portion 1321 may be configured as a flat sheet, a wavy sheet, or an inclined sheet. The sizes of the circulation channels LP formed by all the heat dissipation portions 1321 may be different from each other, or may be completely the same, or may be partially the same, which is not specifically limited herein.

According to some embodiments of present application, referring to FIG. 14 to FIG. 16, the power conversion system 100 further includes an air guide member 180. The air guide member 180 is disposed in the accommodating cavity and located on a fluid path of the annular airflow.

The air guide member 180 is a component for guiding airflow, and is usually made of a material with certain strength and temperature resistance, such as plastic, metal or composite material. The air guide member 180 may be configured to be curved, inclined, branched, or the like, so as to guide the airflow. For example, the air guide member 180 may be a plate having an arc, which can guide the airflow from one region to another region.

The air guide member 180 is provided on the fluid path of the annular airflow, so that the airflow can be guided to flow in a required direction and path, and the airflow is more evenly distributed in the accommodating cavity. The airflow can participate in a heat dissipation process more efficiently, thereby improving utilization of the airflow, and improving a heat dissipation effect and overall performance of the power conversion system 100.

According to some embodiments of present application, still referring to FIG. 14 to FIG. 16 and FIG. 17, in all the airflow generating members 131, along a flow direction of the annular airflow, an airflow generating member 131 adjacent to the heat dissipation member 132 and located downstream of the heat dissipation member 132 is defined as a first generating member 131a, and an airflow generating member 131 adjacent to the heat dissipation member 132 and located upstream of the heat dissipation member 132 is defined as a second generating member 131b. The air guide member 180 includes a first air guide unit 181 and a second air guide unit 182. Along the flow direction of the annular airflow, the first air guide unit 181 is located downstream of the first generating member 131a, and the second air guide unit 182 is located downstream of the second generating member 131b.

The first air guide unit 181 is located downstream of the first generating member 131a, and can guide the airflow accelerated or redirected by the first generating member 131a, so that the airflow better fits the structure downstream of the heat dissipation member 132, and the downstream region of the heat dissipation member 132 can also be fully cooled. Similarly, the second air guide unit 182 is located downstream of the second generating member 131b, and can guide the airflow flowing out from the second generating member 131b, so that the airflow flows to the heat dissipation member 132 more smoothly, thereby improving the cooling effect of the upstream region of the heat dissipation member 132, so that the airflow distribution around the entire heat dissipation member 132 is more uniform, and the heat exchange efficiency is increased.

As such, the arrangement enables the air guide units to cooperate with the airflow generating member 131 and the heat dissipation member 132 more closely. The first air guide unit 181 and the second air guide unit 182 can optimize and guide the airflow upstream and downstream of the heat dissipation member 132, and cooperate with the corresponding first generating member 131a, second generating member 131b and heat dissipation member 132 to form a more efficient heat dissipation system. In addition, by arranging the air guide units according to the positions of the airflow generating member 131 and the heat dissipation member 132, the space in the accommodating cavity can be better utilized. The first air guide unit 181 and the second air guide unit 182 can be reasonably designed according to the shape and size of the space at the position, so as to fully fill the empty space in the airflow channel, effectively guide the airflow without increasing the space occupation, improve the utilization rate of the space in the accommodating cavity, and make the structure of the power conversion system 100 more compact.

According to some embodiments of present application, referring to FIG. 14, FIG. 16, and FIG. 17, the first air guide unit 181 includes a plurality of air deflectors 1811. All the air deflectors 1811 are arranged at intervals in the flow direction of the annular airflow.

By arranging the air deflectors 1811 at intervals, the airflow passing through the first generating member 131a can be further subdivided, so that the airflow is more evenly distributed on the entire annular airflow path. The gap between two adjacent air deflectors 1811 allows the airflow to pass through, which addresses the problem that the airflow is concentrated in some areas, so that each part downstream of the heat dissipation member 132 can obtain a relatively balanced cooling airflow, thereby improving the uniformity of heat dissipation. In addition, the air deflectors 1811 arranged at intervals can allow the airflow to pass through enough space while guiding the airflow, reduce the contact area between the airflow and the air deflectors 1811, thereby reducing the airflow resistance, enabling the airflow to flow in the accommodating cavity with lower energy consumption, and improving the efficiency of the entire heat dissipation system.

It should be noted that the temperature of the airflow passing through the heat dissipation member 132 is relatively low, and since the air deflector 1811 is located downstream of the heat dissipation member 132, the airflow with a relatively low temperature can be guided to a component that needs to dissipate heat. In addition, after the airflow with a relatively low temperature flows through the air deflector 1811, convection may be formed with the first side c1 of the liquid cooling member 110, to accelerate and take away the heat absorbed by the liquid cooling member 110, and meanwhile, circulation of the working medium in the heat pipe 140 can be promoted. It should be understood that the plurality of air deflectors 1811 arranged at intervals are used to guide the airflow with a relatively low temperature, and the speed, direction and turbulence degree of the airflow can be adjusted, so that the airflow can be attached to the surface of related components at a required angle to form a "directional cooling air curtain", thereby improving the heat dissipation efficiency of a local overheating part, and further improving the overall temperature uniformity.

According to some embodiments of the present application, referring to FIG. 14, FIG. 16, and FIG. 17, the accommodating cavity has a peripheral side wall H disposed around a central axis of the housing 170, and an extending direction of the central axis of the housing 170 is parallel to the first direction F1. The air deflector 1811 is disposed on the peripheral side wall H, and the air deflector 1811 extends from the peripheral side wall H in a direction away from the peripheral side wall H. The air deflector 1811 has a start end e1 and a terminal end e2 opposite to each other. The start end e1 is connected to the peripheral side wall H, and the terminal end e2 is away from the peripheral side wall H. In the flow direction of the annular airflow, the terminal end e2 of a former air deflector 1811 is closer to a latter air deflector 1811 than the start end e1.

In the flow direction of the annular airflow, the terminal end e2 of the former air deflector 1811 is closer to the latter air deflector 1811 than the start end e1. This design forms a structure similar to "relay", which guides the airflow to flow along a required path, reduces the occurrence of airflow turbulence and backflow, makes the airflow flow more smoothly in the accommodating cavity, reduces the airflow resistance, improves the utilization rate of the airflow, and enhances the heat dissipation effect. Meanwhile, the air deflector 1811 is arranged on the peripheral side wall H and extends in a direction away from the peripheral side wall H, which makes full use of the space on the peripheral side of the accommodating cavity, and realizes effective guidance and control of the airflow without occupying too much internal space, which is beneficial to the compact design of the equipment.

According to some embodiments of present application, referring to FIG. 14, FIG. 16, and FIG. 17, the air deflector 1811 is disposed to extend in a linear direction from the start end e1 of the air deflector 1811 to the terminal end e2 of the air deflector 1811.

As such, by providing the linear air deflector 1811, a clear and stable guiding path can be provided for the airflow, so that the airflow passing through the heat dissipation member 132 can flow regularly along the linear direction, which reduces the turbulence and vortex phenomenon of the airflow, thereby guiding the airflow to the target position more efficiently, and improving the accuracy and stability of heat dissipation.

In some other embodiments, the air deflector 1811 may extend in a curve direction from the start end e1 of the air deflector 1811 to the terminal end e2 of the air deflector 1811. As such, the air guide surface of the air deflector 1811 may be a curved surface, and the turning of the airflow can be smoother.

According to some embodiments of present application, referring to FIG. 14, FIG. 16, and FIG. 17, an extending direction of the air deflector 1811 from the start end e1 of the air deflector 1811 to the terminal end e2 of the air deflector 1811 is defined as a reference direction. The reference directions corresponding to all the air deflectors 1811 are parallel to each other. That is, the inclined direction of each air deflector 1811 relative to the peripheral side wall H is substantially the same.

As such, not only the airflow can flow in a uniform and more regular direction, thereby forming an ordered airflow field in the accommodating cavity, improving the efficiency and accuracy of airflow guidance, but also the resistance to the airflow during the flowing process is relatively stable, which helps to maintain the stability and continuity of the airflow and make the performance of the heat dissipation system more stable and reliable.

According to some embodiments of present application, still referring to FIG. 14 to FIG. 17, the second air guide unit 182 is configured as a cover. The second air guide unit 182 has an air inlet k1 and an air outlet k2 opposite to each other and in communication with each other, and the second generating member 131b is provided at the air inlet k1.

Since the second air guide unit 182 is located downstream of the second generating member 131b and upstream of the heat dissipation member 132, the airflow generated by the second generating member 131b may be concentrated and guided to the heat dissipation member 132. It should be understood that, compared with the airflow downstream of the first generating member 131a and upstream of the second generating member 131b, the temperature of the airflow downstream of the second generating member 131b is relatively high, and the density of the hot airflow is relatively low, which naturally flows upward. The second air guide unit 182 configured as a cover can limit the flow path of the airflow, enhance a forced convection heat exchange effect between the airflow and the heat dissipation member 132, thereby further improving the heat dissipation performance.

According to some embodiments of present application, still referring to FIG. 14 to FIG. 17, the second air guide unit 182 includes a first air guide wall 1821 and a second air guide wall 1822. The first air guide wall 1821 is disposed on the first side c1 of the liquid cooling member 110. The second air guide wall 1822 is disposed at an end of the first air guide wall 1821 away from the liquid cooling member 110. A side of the first air guide wall 1821 facing the central axis of the housing 170, the second air guide wall 1822, and the first side c1 of the liquid cooling member 110 cooperatively enclose an air guide channel WP having an opening I. An inlet of the air guide channel WP forms the air inlet k1, and an outlet of the air guide channel WP forms the air outlet k2. The opening I is disposed opposite to the first air guide wall 1821, and the opening I is in communication with the air inlet k1 and the air outlet k2.

By providing the opening I, the side of the air guide channel WP close to the central axis of the housing 170 is in communication with the accommodating cavity. During the flowing process of the airflow, the opening I helps to balance the air pressure inside and outside the air guide channel WP, thereby facilitating the airflow to reach the heat dissipation member 132 through the air guide channel WP. In addition, the opening I can play a role of buffering and silencing. When the airflow flows in the air guide channel WP, noise may be generated, the opening I makes the airflow have a certain buffer space, and part of the noise energy may be released and attenuated at the opening I, thereby reducing the noise generated during the operation of the entire heat dissipation system.

According to some embodiments of present application, referring to FIG. 14 to FIG. 17, the second air guide wall 1822 includes a first air guide section E1 and a second air guide section E2 along a direction away from the second generating member 131b. The first air guide section E1 is connected to the second air guide section E2. One end of the first air guide section E1 close to the first generating member 131a is a first air guide end, and one end of the first air guide section E1 connected to the second air guide section E2 is a second air guide end. The second air guide end is closer to the first side c1 of the liquid cooling member 110 than the first air guide end. The first air guide section E1 extends in a linear direction between the first air guide end and the second air guide end. One end of the second air guide section E2 connected to the first air guide section E1 is a third air guide end, and one end of the second air guide section E2 away from the first air guide section E1 is a fourth air guide end. The fourth air guide end is closer to the first side c1 of the liquid cooling member 110 than the third air guide end. The second air guide section E2 extends in a linear direction between the third air guide end and the fourth air guide end. An angle between a direction from the first air guide end to the second air guide end and the first direction F1 is defined as a first angle, and an angle between a direction from the third air guide end to the fourth air guide end and the first direction F1 is defined as a second angle. The first angle is less than the second angle. That is, the second air guide section E2 is steeper than the first air guide section E1.

As such, by designing the second air guide section E2 to be steeper, the airflow channel is narrowed in this section, so that the speed of the airflow will increase when passing through the second air guide section E2. The airflow can quickly exchange heat with the first side c1 of the liquid cooling member 110 and the component located at the second air guide section E2, thereby improving the heat dissipation efficiency, further enhancing the forced convection heat exchange effect between the airflow and the heat dissipation member 132, and further improving the heat dissipation performance.

Therefore, with reference to the content shown in some of the foregoing embodiments, the first air guide unit 181 and the second air guide unit 182 cooperate with each other to guide air in different manners in different regions of the annular airflow, so that a heat dissipation effect of the annular airflow on related components can be further improved.

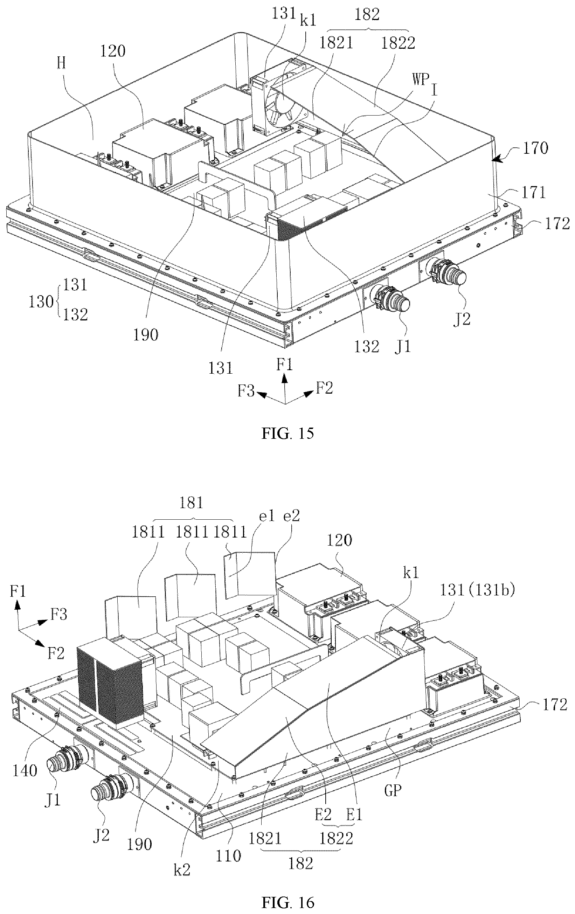

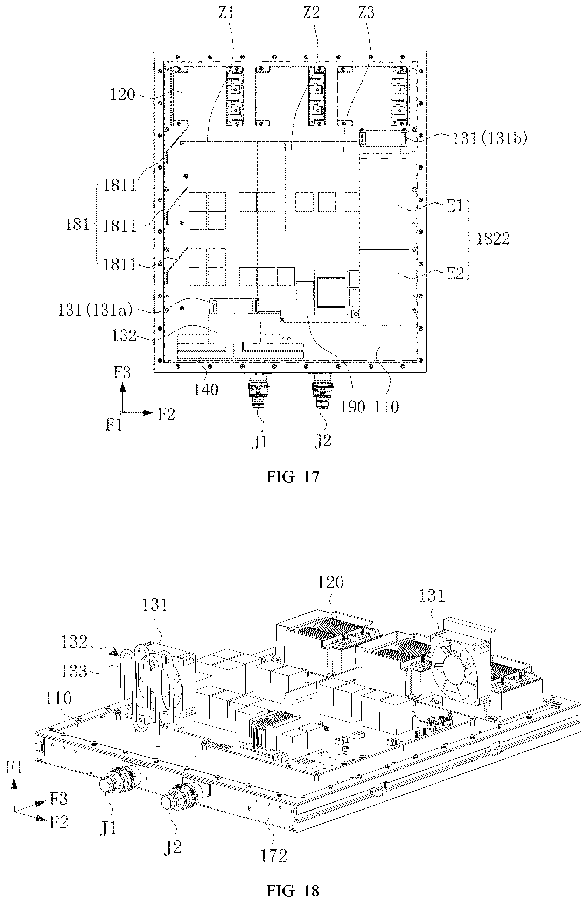

According to some embodiments of present application, still referring to FIG. 16 and FIG. 17, the power conversion system 100 further includes a circuit board assembly 190 disposed on the first side c1 of the liquid cooling member 110. The circuit board assembly 190 includes a circuit board and a plurality of electronic elements disposed on the circuit board. The circuit board has a first zone Z1, a second zone Z2, and a third zone Z3 disposed along the second direction F2. The plurality of electronic elements are disposed in the first zone Z1, the second zone Z2, and the third zone Z3. The second air guide wall 1822 is located on a side of the circuit board assembly 190 away from the liquid cooling member 110. The first zone Z1 is an area disposed close to the first air guide unit 181. The third zone Z3 is an area disposed close to the second air guide unit 182. The average heat generation amount of all electronic elements provided in the first zone Z1 is greater than that of all electronic elements provided in the third zone Z3. The average heat generation amount of all electronic elements provided in the third zone Z3 is greater than that of all electronic elements provided in the second zone Z2.

In the embodiments of present application, the heat generation amount refers to a value of heat emitted by the electronic element when the electronic element works to a stable state (the heating value is relatively stable) at a rated voltage. Taking all the electronic elements disposed in the first zone Z1 as an example, the corresponding rated voltages of all the electronic elements disposed in the first zone Z1 may be different or may be the same. The average heat generation amount of all the electronic elements disposed in the first zone Z1 may be an average value of heating values corresponding to all the electronic elements disposed in the first zone Z1 when all the electronic elements disposed in the first zone Z1 work to a stable state at rated voltages corresponding to respective electronic elements. "Average heat generation amount of all electronic elements provided in the second zone Z2" and "average heat generation amount of all electronic elements provided in the third zone Z3" may be understood with reference to "average heat generation amount of all electronic elements provided in the first zone Z1", and are not repeated herein.

The electronic element with a small heat generation amount is less affected by the ambient temperature, therefore the electronic element with a large heat generation amount and the electronic element with a large heat generation amount are arranged in different regions, which can reduce the thermal interference of the electronic element with a large heat generation amount to the electronic element with a small heat generation amount. Since the temperature of the airflow at the first air guide unit 181 is lower than the temperature of the airflow at the second air guide unit 182, the heat of the first zone Z1 may be taken away more than the heat of the third zone Z3, and the heat of the third zone Z3 may be taken away more than the heat of the second zone Z2, so that the formed annular airflow, the first air guide unit 181 and the second air guide unit 182 cooperate with each other to dissipate heat from different zones, which helps to improve the heat dissipation effect and the temperature uniformity.

According to some embodiments of the present application, referring to FIG. 16, the circuit board in the circuit board assembly 190 is spaced apart from the first side c1 of the liquid cooling member 110 along the first direction F1, and a spacing channel GP is defined. A part of the outlet of the second generating member 131b is in communication with the air inlet k1 of the second air guide unit 182, and another part of the outlet of the second generating member 131b is in communication with the spacing channel GP.

As such, the airflow flowing out from the outlet of the second generating member 131b can dissipate heat from the liquid cooling member 110 and the circuit board through two different paths. On the one hand, the air guide unit guides the airflow to perform centralized heat dissipation on the first side c1 of the liquid cooling member 110; on the other hand, the airflow in the spacing channel GP can directly act on the circuit board in the circuit board assembly 190 to take away the heat generated by the circuit board, and can also perform heat dissipation on the side of the liquid cooling member 110 close to the circuit board. It should be understood that the circuit board can divide the airflow flowing out from the outlet of the second generating member 131b, so that the airflow can be more evenly distributed on and around the surface of the circuit board, the contact area between the airflow and the circuit board is increased, the convection heat exchange process is enhanced, and the heat on the circuit board is taken away more effectively.

Referring to FIG. 18, in another embodiment, the heat dissipation member 132 includes at least one pipe 133. An inlet of the pipe 133 and an outlet of the pipe 133 are both in communication with the liquid cooling channel UP, so that liquid in the liquid cooling channel UP can flow into the pipe 133 through an inlet of the pipe 133, and flow out of the pipe 133 through an outlet of the pipe 133.

By communicating an interior of the pipe 133 with the liquid cooling channel UP of the liquid cooling member 110, the liquid in the liquid cooling channel UP can flow into the pipe 133 via the inlet of the pipe 133, and flow out of the liquid flow path of the pipe 133 from the outlet of the pipe 133, so that the pipe 133 located on the first side c1 of the liquid cooling member 110 can be cooled by the liquid in the liquid cooling channel UP. Since the heat dissipation member 132 is located on the airflow path generated by the air cooling assembly 130, the airflow generated by the air cooling assembly 130 can be cooled via the pipe 133, so that the plurality of devices 120 on the first side c1 of the liquid cooling member 110 can be cooled, thereby further improving the thermal management effect of the power conversion system 100.

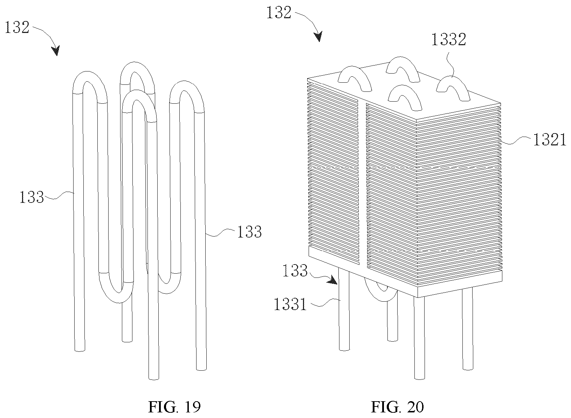

Referring to FIG. 19, a plurality of pipes 133 are provided. All the pipes 133 are arranged at intervals along the extending direction of the airflow path generated by the air cooling assembly 130. It will be appreciated that two, three, or other numbers of pipes 133 may be provided.

Since all the pipes 133 are arranged at intervals, the airflow can more fully contact each pipe 133, and the cooling capacity of the pipes 133 is utilized to the greatest extent. When the airflow flows between the pipes 133, it can fully exchange heat with the surface of the pipe 133, so that the cooling capacity in the pipe 133 is fully utilized, and the cooling efficiency is improved.

Referring to FIG. 20, the heat dissipation member 132 further includes a plurality of heat dissipation portions 1321, and the pipe 133 is fitted with the heat dissipation portion 1321. The heat dissipation portion 1321 may be configured to cooperate with the pipe 133 to implement heat exchange with the airflow. The heat dissipation portion 1321 may be a component that is easy to perform heat transfer, or may be a component that is used to define a channel that facilitates airflow flowing through the pipe 133, which is not specifically limited herein.

By providing the heat dissipation portion 1321 on the pipe 133, the cold energy of the liquid in the pipe 133 can be transferred to the heat dissipation portion 1321, so that the contact area for heat exchange with the airflow can be increased, thereby facilitating more sufficient cooling of the airflow and improving the heat exchange effect.

According to some embodiments of present application, at least a part of the pipe 133 extends through the heat dissipation portion 1321.

Since the pipe 133 at least partially extends through the heat dissipation portion 1321, the cold energy in the pipe 133 can be more directly and quickly transferred to the heat dissipation portion 1321. As such, a cold energy transfer path is shorter, which is more conducive to more sufficient cooling of the airflow. In addition, a structural design in which the pipe 133 cooperates with the heat dissipation portion 1321 does not need to reserve additional space for connection and arrangement between the pipe 133 and the heat dissipation portion 1321, so that a more compact spatial layout can be implemented.

As shown in FIG. 20, the pipe 133 includes a plurality of extending sections 1331 arranged at intervals, and at least one connecting section 1332. The plurality of extending sections 1331 are connected in series by at least one connecting section 1332. Along the serial direction of the plurality of extending sections 1331, the inlet of the first extending section 1331 is the inlet of the pipe 133, and the outlet of the last extending section 1331 is the outlet of the pipe 133. At least one connecting section 1332 extends from the heat dissipation portion 1321 along the first direction F1.

The extending section 1331 constitutes a main portion of the pipe 133, and the connecting section 1332 is a structure that connects all the extending sections 1331 in series. The number of the connecting sections 1332 is related to the number of the extending sections 1331, as long as all the extending sections 1331 can be connected in series, which is not specifically limited herein. For example, when two extending sections 1331 are provided, one connecting section 1332 is provided. When four extending sections 1331 are provided, three connecting sections 1332 are provided. The first extending section 1331 and the last extending section 1331 are both connected to the first side c1 of the liquid cooling member 110.

The plurality of extending sections 1331 are connected in series by using the at least one connecting section 1332, which means that the plurality of extending sections 1331 are sequentially connected end to end by using the at least one connecting section 1332, so that the liquid can flow in from the inlet of the first extending section 1331, sequentially pass through the extending sections 1331, and finally flow out from the outlet of the last extending section 1331. As such, the liquid can flow orderly in the pipe 133.

When the airflow passes through the connecting section 1332 extending out of the heat dissipation portion 1321, the connecting section 1332 can divide the airflow, so that the airflow generates more turbulence and vortices, breaks the airflow boundary layer, increases the contact area and contact time of the airflow with the connecting section 1332 and the heat dissipation portion 1321, and makes the heat transfer more sufficient. At the same time, the airflow divided by the connecting section 1332 extending out of the heat dissipation portion 1321 may be mixed with each other, so that the temperature distribution is more uniform, thereby facilitating the airflow to dissipate heat from components such as the device 120 located on the first side c1 of the liquid cooling member 110. In addition, such a structure of the pipe 133 may increase the length of the pipe 133, thereby extending the time for the liquid to flow through the pipe 133 in a limited space. When the first direction F1 and the gravity direction are parallel to each other, the gravity of the liquid also needs to be overcome when the liquid flows in the pipe 133, so that the time for the liquid to flow through the pipe 133 can be further prolonged, thereby prolonging the heat exchange time. Therefore, the pipe 133 may further improve the heat exchange effect.

As shown in FIG. 20, a plurality of connecting sections 1332 are provided, all the connecting sections 1332 are distributed on two sides of the heat dissipation portion 1321 along the first direction F1, and the number of connecting sections 1332 on two sides of the heat dissipation portion 1321 along the first direction F1 is different.

As such, the airflow may be divided by the connecting section 1332 on both sides of the heat dissipation portion 1321 along the first direction F1. Since the number of the connecting sections 1332 on the two sides of the heat dissipation portion 1321 along the first direction F1 is different, when the airflow passes through the heat dissipation member 132, the airflow on the two sides of the heat dissipation portion 1321 along the first direction F1 will be disturbed by different structures to form a complex flow path, thereby generating more turbulence and disturbance, which is conducive to enhancing the heat exchange effect.

According to some embodiments of present application, still referring to FIG. 1, the power conversion system 100 may include at least one of a photovoltaic interface, a battery interface, a grid input interface, a direct current output interface, and an alternating current output interface. The power conversion system 100 of the solar cell or other renewable energy power generation system may be connected through a battery interface or a photovoltaic interface. The battery may store electric energy, which can be converted and output by using the power conversion system 100. The power grid input interface may be connected to high-voltage electric energy of a power grid, and is output to a low-voltage power device or system after being stepped down by using the power conversion system 100. The alternating current output interface may be connected to products requiring alternating current such as household appliances, and the power conversion system 100 converts alternating current into direct current and outputs the direct current to the appliance. The direct current output interface may be connected to a device that requires direct current electricity such as a charging pile.

As such, flexibility may be configured based on an actual use requirement, so as to improve adaptability of the power conversion system 100 and meet use requirements in different scenarios.

According to some embodiments of present application, an energy storage system is provided, including the power conversion system 100 in any one of the foregoing embodiments.

In some embodiments, the energy storage system further includes a battery, and the power conversion system 100 is electrically connected to the battery. The power conversion system 100 may convert energy generated by solar energy, wind power generation, or a fuel cell into a direct current, and store the direct current in a battery, and output electric energy in the battery when the battery needs to be used. The energy storage system can provide users with reliable energy reserves and provide users with backup power in the event of power outages or power shortages, making it convenient for users to use.

The energy storage system also has the advantages of the power conversion system 100, and details are not described herein again.

According to some embodiments of present application, an electrical equipment is provided, including the power conversion system 100 in any one of the foregoing embodiments.

In some embodiments, the electrical equipment further includes a battery, the battery is used as a power supply of the electrical equipment, and the power conversion system 100 is electrically connected to the battery. For example, the electrical equipment may be but is not limited to a charging station, a power distribution device, a power generation system, an energy storage system, and the like.

The electrical equipment also has the advantages of the above power conversion system 100, which is not specifically limited herein.

## Claims

1. A power conversion system, comprising:
a liquid cooling member having a liquid cooling channel, the liquid cooling member having a first side and a second side opposite to each other along a first direction, the first side having a plurality of mounting regions;
a plurality of devices disposed in the plurality of mounting regions in one-to-one correspondence;
an air cooling assembly disposed on the first side, the air cooling assembly comprising an airflow generating member and a heat dissipation member, and the heat dissipation member being located on an airflow path generated by the airflow generating member; and
a plurality of heat pipes disposed in the plurality of mounting regions in one-to-one correspondence, wherein one end of each heat pipe is located in the corresponding mounting region, the other end of the heat pipe is located between the heat dissipation member and the liquid cooling member, and the heat dissipation member is attached to a side of the heat pipe away from the liquid cooling member.

2. The power conversion system according to claim 1, further comprising a plurality of heat spreaders, wherein the plurality of heat spreaders are disposed in the plurality of mounting regions in a one-to-one correspondence, a side of each heat spreader away from the liquid cooling member is provided with a corresponding device, and mounting regions corresponding to the heat spreader and the corresponding device are the same mounting region.

3. The power conversion system according to claim 2, wherein the heat spreader is embedded in the first side of the liquid cooling member; and/or
one end of the heat pipe located in the corresponding mounting region is connected to a corresponding heat spreader, and mounting regions corresponding to the heat pipe and the corresponding heat spreader are the same mounting region.

4. The power conversion system according to any one of claims 1 to 3, wherein the liquid cooling channel comprises a first buffer section and a main section, the first buffer section is in communication with an inlet of the liquid cooling channel, and the main section is in communication with the first buffer section and an outlet of the liquid cooling channel; wherein an orthographic projection of the first buffer section on a reference plane, an orthographic projection of the heat pipe on the reference plane, and an orthographic projection of the heat dissipation member on the reference plane have overlapping portions, an orthographic projection of the main section on the reference plane and orthographic projections of the plurality of devices on the reference plane have overlapping portions, and the reference plane is a plane perpendicular to the first direction.

5. The power conversion system according to claim 4, further comprising a plurality of flow disturbing structures arranged at intervals and disposed in the first buffer section.

6. The power conversion system according to claim 5, wherein from the inlet of the liquid cooling channel to the outlet of the liquid cooling channel, an extending direction of the liquid cooling channel is a reference direction, and along the reference direction, a distribution density of the plurality of flow disturbing structures in a unit space region of the liquid cooling channel decreases.

7. The power conversion system according to any one of claims 1 to 3, further comprising a housing, wherein the housing has a receiving cavity, the liquid cooling member is disposed in the receiving cavity, the first side of the liquid cooling member and a cavity wall of the receiving cavity define an accommodating cavity, and the plurality of devices and the air cooling assembly are disposed in the accommodating cavity;
wherein a plurality of airflow generating members are provided, the airflow generating members are configured to generate an annular airflow arranged around an axis in the accommodating cavity, the heat dissipation member is located on a path of the annular airflow, and an extending direction of the axis and the first direction are parallel to each other.

8. The power conversion system according to claim 7, wherein the heat dissipation member comprises at least one column of a plurality of heat dissipation portions arranged at intervals in the first direction, and each column of heat dissipation portions defines a circulation channel;
wherein an inlet side of one of the airflow generating members is connected to one side of the heat dissipation member, and an inlet of the one of the airflow generating members is in communication with the circulation channel.

9. The power conversion system according to claim 7, further comprising an air guide member disposed in the accommodating cavity and located on the path of the annular airflow.

10. The power conversion system according to claim 9, wherein the plurality of airflow generating members comprise a first generating member adjacent to the heat dissipation member and located downstream of the heat dissipation member, and a second generating member adjacent to the heat dissipation member and located upstream of the heat dissipation member in a flow direction of the annular airflow;
wherein the air guide member comprises a first air guide unit and a second air guide unit; along the flow direction of the annular airflow, the first air guide unit is located downstream of the first generating member, and the second air guide unit is located downstream of the second generating member.

11. The power conversion system according to claim 10, wherein the first air guide unit comprises a plurality of air deflectors, and the plurality of air deflectors are arranged at intervals in the flow direction of the annular airflow.

12. The power conversion system according to claim 11, wherein the accommodating cavity has a peripheral side wall surrounding a central axis of the housing, and an extending direction of the central axis of the housing is parallel to the first direction;
wherein the air deflectors are disposed on the peripheral side wall, each air deflector extends from the peripheral side wall in a direction away from the peripheral side wall, the air deflector has a start end and a terminal end opposite to each other, the start end is connected to the peripheral side wall, and the terminal end is away from the peripheral side wall;
wherein along the flow direction of the annular airflow, the terminal end of a former air deflector is closer to a latter air deflector than the start end.

13. The power conversion system according to claim 10, wherein the second air guide unit is configured as a cover, the second air guide unit has an air inlet and an air outlet disposed opposite to each other and in communication with each other, and the second generating member is disposed at the air inlet.

14. The power conversion system according to claim 13, wherein the second air guide unit comprises:
a first air guide wall disposed on the first side of the liquid cooling member; and
a second air guide wall disposed at an end of the first air guide wall away from the liquid cooling member;
wherein a side of the first air guide wall facing a central axis of the housing, the second air guide wall, and the first side of the liquid cooling member cooperatively enclose an air guide channel having an opening, an inlet of the air guide channel forms the air inlet, and an outlet of the air guide channel forms the air outlet;
wherein the opening is disposed opposite to the first air guide wall, and the opening is in communication with the air inlet and the air outlet.

15. The power conversion system according to any one of claims 1 to 14, wherein the heat dissipation member comprises a pipe, and an inlet and an outlet of the pipe are both in communication with the liquid cooling channel, so that liquid in the liquid cooling channel can flow into the pipe through the inlet of the pipe, and flow out of the pipe from the outlet of the pipe.
